# EUROPEAN PATENT APPLICATION

(11) **EP 4 685 798 A1**
(43) Date of publication of application: **28.01.2026**
(21) Application number: 23930112.0
(22) Date of filing: 19.12.2023
(51) Int. Cl.: G11C 11/22

(54) **MEMORY CONTROL METHOD, APPARATUS AND ELECTRONIC DEVICE**

(30) Priority: 31.03.2023 CN 202310379243
(71) Applicant: HUAWEI TECHNOLOGIES CO., LTD., Shenzhen 518129 (CN)
(72) Inventor: YIN, Shihui, Shenzhen, Guangdong 518129 (CN); JING, Weiliang, Shenzhen, Guangdong 518129 (CN); WANG, Tong, Shenzhen, Guangdong 518129 (CN); JI, Bingwu, Shenzhen, Guangdong 518129 (CN); WANG, Zhengbo, Shenzhen, Guangdong 518129 (CN); LIAO, Heng, Shenzhen, Guangdong 518129 (CN)
(74) Representative: Isarpatent
(86) International application number: PCT/CN2023/139997
(87) International publication number: WO 2024/198548

(57) **Abstract**

Embodiments of this application provide a control method and apparatus for a memory, and an electronic device, and relate to the field of storage technologies. The memory includes a plurality of transistors and a memory cell array. Memory cells located in a same column are coupled to a same transistor and a same word line, the plurality of transistors are all coupled to a bit line, and memory cells located in a same row are coupled to a same plate line. The method includes: in a first sub-phase of an active phase, conducting, through an unselected word line, a transistor coupled to the unselected word line, applying a first voltage V1 to the bit line, and applying a second voltage V2 to an unselected plate line; and in a second sub-phase of the active phase, conducting, through a selected word line, a transistor coupled to the selected word line, applying a third voltage V3 to the bit line, and applying a fourth voltage V4 to a selected plate line, where |V4-V3|=Vw, |V4-V1|<1/2Vw, and |V3-V2|<1/2Vw. An amplitude of an interference voltage is reduced by reducing a voltage difference between two ends of an unselected memory cell, to resolve a problem of high refresh frequency.

## Description

This application claims priority to Chinese Patent Application No. 202310379243X, filed with the China National Intellectual Property Administration on March 31, 2023 and entitled "CONTROL METHOD AND APPARATUS FOR MEMORY, AND ELECTRONIC DEVICE", which is incorporated herein by reference in its entirety.

### TECHNICAL FIELD

Embodiments of this application relate to the field of storage technologies, and in particular, to a control method and apparatus for a memory, and an electronic device.

### BACKGROUND

Miniaturization in size of a conventional planar dynamic random access memory (Dynamic Random Access Memory, DRAM) based on a one-transistor one-capacitor (1 transistor 1 capacitor, 1T1C) structure becomes increasingly difficult, and a three-dimensional ferroelectric memory based on a one-transistor multi-capacitor (1 transistor n capacitor, 1TnC) structure can better improve a memory integration density. Similar to the conventional DRAM, in a reading process, a change of a charge on a bit line (bit line, BL) causes a change of a voltage on the BL. The change of the voltage on the BL may be read and amplified by using a sense amplifier (sense amplifier, SA), and data of a memory cell may be read. Different from the conventional DRAM, the change of the charge on the BL is mainly caused by a polarization charge released by a ferroelectric capacitor due to polarity switching when the ferroelectric capacitor of the memory cell is under an action of a voltage that exceeds a coercive field voltage Vc. When the ferroelectric memory is accessed, the ferroelectric capacitor needs to be refreshed periodically, and a problem of high refresh frequency exists in the conventional technology.

### SUMMARY

Embodiments of this application provide a control method and apparatus for a memory, and an electronic device, to resolve a problem of high refresh frequency in the conventional technology.

To achieve the foregoing objectives, the following technical solutions are used in embodiments of this application.

According to a first aspect, a control method for a memory is provided, where the memory includes a plurality of transistors, a memory cell array, a bit line, a plurality of word lines, and a plurality of plate lines, memory cells located in a same column in the memory cell array are coupled to a same transistor and a same word line, the plurality of transistors are all coupled to the bit line, and memory cells located in a same row in the memory cell array are coupled to a same plate line; and the method includes:
in a first sub-phase of an active phase of a target memory cell, conducting, through an unselected word line, a transistor coupled to the unselected word line, applying a first voltage V1 to the bit line, and applying a second voltage V2 to an unselected plate line, where a word line and a plate line that are coupled to the target memory cell are respectively a selected word line and a selected plate line, the unselected word line is a word line other than the selected word line in the plurality of word lines, and the unselected plate line is a plate line other than the selected plate line in the plurality of plate lines; and
in a second sub-phase of the active phase, conducting, through the selected word line, a transistor coupled to the selected word line, applying a third voltage V3 to the bit line, and applying a fourth voltage V4 to the selected plate line, where |V4-V3|=Vw, |V4-V1|<1/2Vw, and |V3-V2|<1/2Vw.

In the foregoing technical solution, a voltage difference between two ends of the unselected memory cell other than the target memory cell in the memory cell array is reduced, that is, an amplitude of an interference voltage is reduced, so that read/write interference to the memory cell array is reduced, a size of an information read window is not reduced, a quantity of read/write interference resistance times of the memory cell array is increased, a refresh frequency of a ferroelectric memory is reduced, implementability of a ferroelectric memory is improved, and performance of the ferroelectric memory is enhanced.

In a possible implementation of the first aspect, |V4-V1|=|V3-V2|=|V1-V2|=(1/3)Vw. In the foregoing possible implementation, the voltage difference between the two ends of the unselected memory cell in the memory cell array other than the target memory cell is (1/3)Vw, so that the voltage difference between the two ends of the unselected memory cell is less than (1/2)Vw, a size of an information read window is not reduced, a refresh frequency of a ferroelectric memory is reduced, implementability of a ferroelectric memory is improved, and performance of the ferroelectric memory is enhanced.

In a possible implementation of the first aspect, the active phase is used to write first data into the target memory cell, V4=Vw, V3=0, V2=(1/3)Vw, and V1=(2/3)Vw; or the active phase is used to write second data into the selected memory cell, V4=0, V3=Vw, V2=(2/3)Vw, and V1=(1/3)Vw. In the foregoing possible implementation, the voltage difference between the two ends of the unselected memory cell in the memory cell array other than the target memory cell is (1/3)Vw, so that the voltage difference between the two ends of the unselected memory cell is less than (1/2)Vw, a size of an information read window is not reduced, a refresh frequency of a ferroelectric memory is reduced, implementability of a ferroelectric memory is improved, and performance of the ferroelectric memory is enhanced.

In a possible implementation of the first aspect, the memory further includes a sense amplifier coupled to the bit line, and if the active phase is used to write the first data into the target memory cell, before the applying the fourth voltage V4 to the selected plate line in the second sub-phase of the active phase, the method further includes: cutting off, through the selected word line, the transistor coupled to the selected word line. After applying the fourth voltage V4 to the selected plate line, the method further includes: conducting, through the selected word line, the transistor coupled to the selected word line in a third sub-phase of the active phase; and storing first target data of the target memory cell into the sense amplifier based on a voltage of the bit line, where the first target data is the second data or the first data. In the foregoing possible implementation, in a process of storing the first target data of the target memory cell into the sense amplifier, the voltage difference between the two ends of the unselected memory cell other than the target memory cell in the memory cell array is reduced, so that a size of an information read window is not reduced, a refresh frequency of a ferroelectric memory is reduced, implementability of a ferroelectric memory is improved, and performance of the ferroelectric memory is enhanced.

In a possible implementation of the first aspect, the method further includes: reading the first target data from the sense amplifier in a read phase of the target memory cell. In the foregoing possible implementation, in a process of reading the first target data, the voltage difference between the two ends of the unselected memory cell other than the target memory cell in the memory cell array is reduced, so that a size of an information read window is not reduced, a refresh frequency of a ferroelectric memory is reduced, implementability of a ferroelectric memory is improved, and performance of the ferroelectric memory is enhanced.

In a possible implementation of the first aspect, the method further includes: deleting the first target data from and writing second target data into the sense amplifier in a write phase of the target memory cell, where the second target data is the second data or the first data. In the foregoing possible implementation, in a process of writing the second target data, the voltage difference between the two ends of the unselected memory cell other than the target memory cell in the memory cell array is reduced, so that a size of an information read window is not reduced, a refresh frequency of a ferroelectric memory is reduced, implementability of a ferroelectric memory is improved, and performance of the ferroelectric memory is enhanced.

In a possible implementation of the first aspect, data in the sense amplifier is the second data, and the method further includes: in a first sub-phase of a precharge phase, conducting, through the unselected word line, the transistor coupled to the unselected word line, applying the second voltage V2 to the bit line, and applying the first voltage V1 to the unselected plate line; and in a second sub-phase of the precharge phase, conducting, through the selected word line, the transistor coupled to the selected word line, applying the fourth voltage V4 to the bit line, and applying the third voltage V3 to the selected plate line. In the foregoing possible implementation, in a process of performing precharge on the data in the sense amplifier, the voltage difference between the two ends of the unselected memory cell other than the target memory cell in the memory cell array is reduced, so that a size of an information read window is not reduced, a refresh frequency of a ferroelectric memory is reduced, implementability of a ferroelectric memory is improved, and performance of the ferroelectric memory is enhanced.

In a possible implementation of the first aspect, data in the sense amplifier is the first data, and the method further includes: in a first sub-phase of a precharge phase, conducting, through the unselected word line, the transistor coupled to the unselected word line, applying the second voltage V2 to the bit line, and applying the first voltage V1 to the unselected plate line; and in a second sub-phase of the precharge phase, conducting, through the selected word line, the transistor coupled to the selected word line, applying the second voltage V2 to the bit line, and applying the third voltage V3 to the selected plate line. In the foregoing possible implementation, in a process of performing precharge on the data in the sense amplifier, the voltage difference between the two ends of the unselected memory cell other than the target memory cell in the memory cell array is reduced, so that a size of an information read window is not reduced, a refresh frequency of a ferroelectric memory is reduced, implementability of a ferroelectric memory is improved, and performance of the ferroelectric memory is enhanced.

In a possible implementation of the first aspect, the method further includes: separately applying the first voltage to the bit line, the selected plate line, and the unselected plate line in a third sub-phase of the precharge phase, to initialize the bit line, the selected plate line, and the unselected plate line. In the foregoing possible implementation, in a process of performing precharge on the data in the sense amplifier, the voltage difference between the two ends of the unselected memory cell other than the target memory cell in the memory cell array is reduced, so that a size of an information read window is not reduced, a refresh frequency of a ferroelectric memory is reduced, implementability of a ferroelectric memory is improved, and performance of the ferroelectric memory is enhanced.

In a possible implementation of the first aspect, the method further includes: performing voltage division on an initial voltage according to different ratios, to obtain the first voltage and the second voltage. In the foregoing possible implementation, the first voltage and the second voltage are obtained through voltage division, to provide a basis for reducing the voltage difference between the two ends of the unselected memory cell other than the target memory cell in the memory cell array, so that a size of an information read window is not reduced, a refresh frequency of a ferroelectric memory is reduced, implementability of a ferroelectric memory is improved, and performance of the ferroelectric memory is enhanced.

According to a second aspect, a control apparatus for a memory is provided, where the memory includes a plurality of transistors, a memory cell array, a bit line, a plurality of word lines, and a plurality of plate lines, memory cells located in a same column in the memory cell array are coupled to a same transistor and a same word line, the plurality of transistors are all coupled to the bit line, and memory cells located in a same row in the memory cell array are coupled to a same plate line. The apparatus includes: a first control circuit, configured to: in a first sub-phase of an active phase of a target memory cell, conduct, through an unselected word line, a transistor coupled to the unselected word line, apply a first voltage V1 to the bit line, and apply a second voltage V2 to an unselected plate line, where a word line and a plate line that are coupled to the target memory cell are respectively a selected word line and a selected plate line, the unselected word line is a word line other than the selected word line in the plurality of word lines, and the unselected plate line is a plate line other than the selected plate line in the plurality of plate lines; and a second control circuit, configured to: in a second sub-phase of the active phase, conduct, through the selected word line, a transistor coupled to the selected word line, apply a third voltage V3 to the bit line, and apply a fourth voltage V4 to the selected plate line, where |V4-V3|=Vw, |V4-V1|<1/2Vw, and |V3-V2|<1/2Vw.

In a possible implementation of the second aspect, |V4-V1|=|V3-V2|=|V1-V2|=(1/3)Vw.

In a possible implementation of the second aspect, the active phase is used to write first data into the target memory cell, V4=Vw, V3=0, V2=(1/3)Vw, and V1=(2/3)Vw; or the active phase is used to write second data into the selected memory cell, V4=0, V3=Vw, V2=(2/3)Vw, and V1=(1/3)Vw.

In a possible implementation of the second aspect, the memory further includes a sense amplifier coupled to the bit line, and the active phase is used to write the first data into the target memory cell. The second control circuit is further configured to: before the fourth voltage V4 is applied to the selected plate line in the second sub-phase of the active phase, cut off, through the selected word line, the transistor coupled to the selected word line. The second control circuit is further configured to conduct, through the selected word line, the transistor coupled to the selected word line in a third sub-phase of the active phase. The second control circuit is further configured to store first target data of the target memory cell into the sense amplifier based on a voltage of the bit line, where the first target data is the second data or the first data.

In a possible implementation of the second aspect, the apparatus further includes a third control circuit, configured to read the first target data from the sense amplifier in a read phase of the target memory cell.

In a possible implementation of the second aspect, the apparatus further includes a fourth control circuit, configured to: delete the first target data from and write second target data into the sense amplifier in a write phase of the target memory cell, where the second target data is the second data or the first data.

In a possible implementation of the second aspect, data in the sense amplifier is the second data, and the first control circuit is further configured to: in a first sub-phase of a precharge phase, conduct, through the unselected word line, the transistor coupled to the unselected word line, apply the second voltage V2 to the bit line, and apply the first voltage V1 to the unselected plate line. The second control circuit is further configured to: in a second sub-phase of the precharge phase, conduct, through the selected word line, the transistor coupled to the selected word line, apply the fourth voltage V4 to the bit line, and apply the third voltage V3 to the selected plate line.

In a possible implementation of the second aspect, data in the sense amplifier is the first data, and the first control circuit is further configured to: in a first sub-phase of a precharge phase, conduct, through the unselected word line, the transistor coupled to the unselected word line, apply the second voltage V2 to the bit line, and apply the first voltage V1 to the unselected plate line. The second control circuit is further configured to: in a second sub-phase of the precharge phase, conduct, through the selected word line, the transistor coupled to the selected word line, apply the second voltage V2 to the bit line, and apply the third voltage V3 to the selected plate line.

In a possible implementation of the second aspect, the apparatus further includes a fifth control circuit, configured to separately apply the first voltage to the bit line, the selected plate line, and the unselected plate line in a third sub-phase of the precharge phase, to initialize the bit line, the selected plate line, and the unselected plate line.

In a possible implementation of the second aspect, the apparatus further includes a voltage divider circuit, and the voltage divider circuit is configured to perform voltage division on an initial voltage according to different ratios, to obtain the first voltage and the second voltage.

According to a third aspect, an electronic device is provided, where the electronic device includes a processor and the control apparatus for a memory provided in any one of the second aspect or the possible implementations of the second aspect.

According to another aspect of embodiments of this application, a computer program product is provided. When the computer program product runs on a computer, the computer is enabled to perform the method according to any one of the first aspect or the possible implementations of the first aspect.

It may be understood that any one of the control apparatus for a memory, the electronic device, or the computer program product provided above is configured to perform the corresponding method provided above. Therefore, for beneficial effects that can be achieved by the control apparatus for a memory, the electronic device, or the computer program product, refer to beneficial effects in the corresponding method provided above. Details are not described herein again.

### BRIEF DESCRIPTION OF DRAWINGS

FIG. 1 is a diagram of a structure of an electronic device according to an embodiment of this application;
FIG. 2 is a diagram of a structure of a memory according to an embodiment of this application;
FIG. 3 is a diagram of a memory of a 1T1C structure according to an embodiment of this application;
FIG. 4 is a diagram of a memory of a 1TnC structure according to an embodiment of this application;
FIG. 5 is a diagram 1 of a memory cell array according to an embodiment of this application;
FIG. 6 is a diagram 2 of a memory cell array according to an embodiment of this application;
FIG. 7 is a schematic flowchart of a control method for a memory according to an embodiment of this application;
FIG. 8 is a diagram 3 of a memory cell array according to an embodiment of this application;
FIG. 9 is a diagram 4 of a memory cell array according to an embodiment of this application;
FIG. 10 is a time sequence diagram of a control method for a memory according to an embodiment of this application; and
FIG. 11 is a diagram of a structure of a control apparatus for a memory according to an embodiment of this application.

### DESCRIPTION OF EMBODIMENTS

The following further describes the technical solutions of this disclosure in detail with reference to accompanying drawings and embodiments. Although example implementation methods of this disclosure are shown in the accompanying drawings, it should be understood that this disclosure may be implemented in various forms and should not be limited by implementations described herein. Instead, these implementations are provided to understand this disclosure more thoroughly and to fully convey the scope of this disclosure to a person skilled in the art.

In the following paragraphs, this disclosure is more specifically described with reference to accompanying drawings by using examples. The advantages and features of this disclosure will be clearer from the following descriptions and claims. It should be noted that the accompanying drawings are all in a very simplified form and a non-precise proportion, and are merely used to conveniently and clearly assist in describing objectives of embodiments of this disclosure.

In embodiments of this disclosure, the terms "first", "second", and the like are intended to distinguish between similar objects but do not necessarily indicate a specific order or sequence. It should be noted that the technical solutions recorded in embodiments of this disclosure may be randomly combined if there is no conflict.

Technical solutions in embodiments of this application may be applied to various electronic devices including a memory. For example, the technical solutions in embodiments of this application may be applied to a computer, a tablet computer, a notebook computer, a mobile phone, a netbook, a wearable device, a vehicle-mounted device, or a camera device. The electronic device in embodiments of this application may include only a memory, or may include both a processor and a memory. In actual application, the electronic device may further include one or more of a plurality of modules such as a communication module, a sensor module, a display module, and an input/output module. A structure of the electronic device is not specifically limited in embodiments of this application.

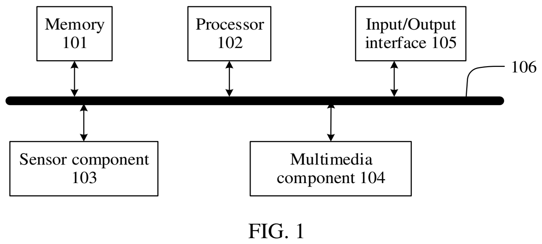

For example, FIG. 1 is a diagram of a structure of an electronic device according to an embodiment of this application. As shown in FIG. 1, the electronic device may include at least a memory 101, a processor 102, a sensor component 103, a multimedia component 104, and an input/output interface 105. In addition, the memory 101, the processor 102, the sensor component 103, the multimedia component 104, and the input/output interface 105 may be connected through a bus 106.

The memory 101 is configured to store a software program and a module. The memory 101 mainly includes a program storage area and a data storage area. The program storage area may store an operating system, an application required by at least one function (such as a sound playing function and an image playing function), and the like. The data storage area may store data (such as audio data, image data, and a phone book) created based on use of the electronic device, and the like. In addition, the memory 101 includes an external memory and an internal memory. Data stored in the external memory and the internal memory may be transmitted to each other. The external memory includes, for example, a hard disk, a USB flash drive, and a floppy disk. The internal memory includes, for example, a random access memory or a read only memory. The random access memory may be, for example, a ferroelectric random access memory (ferroelectric random access memory, FeRAM), which is referred to as a ferroelectric memory for short below, a magnetic random access memory (magnetic random access memory, MRAM), or a dynamic random access memory (dynamic random access memory, DRAM).

The processor 102 is a control center of the electronic device, and connects various parts of the entire device through various interfaces and lines. The processor 102 may include a plurality of cores (core). An operating system and another software program are installed in the processor 102, so that the processor 102 can access the memory 101, a cache, and a magnetic disk. By running or executing a software program and/or a software module stored in the memory 101, and invoking data stored in the memory 101, various functions and data processing of the electronic device are performed, to implement overall monitoring on the electronic device.

The sensor component 103 includes one or more sensors configured to provide the electronic device with status assessment in various aspects. The sensor component 103 may include an optical sensor, an acceleration sensor, a gyroscope sensor, a magnetic sensor, a pressure sensor, or a temperature sensor. The sensor component 103 may detect acceleration/deceleration, an orientation, an on/off state, relative positioning of components, a temperature change, or the like of the electronic device.

The multimedia component 104 may provide a screen of an output interface between the electronic device and a user. When the screen is a touch panel, the screen may be implemented as a touchscreen to receive an input signal from the user. In addition, the multimedia component 104 may further include at least one camera. The camera may be a fixed optical lens system or has a focal length and an optical zooming capability.

The input/output interface 105 provides an interface between the processor 102 and a peripheral interface module. For example, the peripheral interface module may include a keyboard, a mouse, or a USB (universal serial bus) device.

Although not shown, the electronic device may further include an audio component, a communication component, and the like. For example, the audio component includes a microphone, and the communication component includes a wireless fidelity (wireless fidelity, Wi-Fi) module, a Bluetooth module, or the like. Details are not described herein in this embodiment of this application. Details are not described herein again in this embodiment of this application.

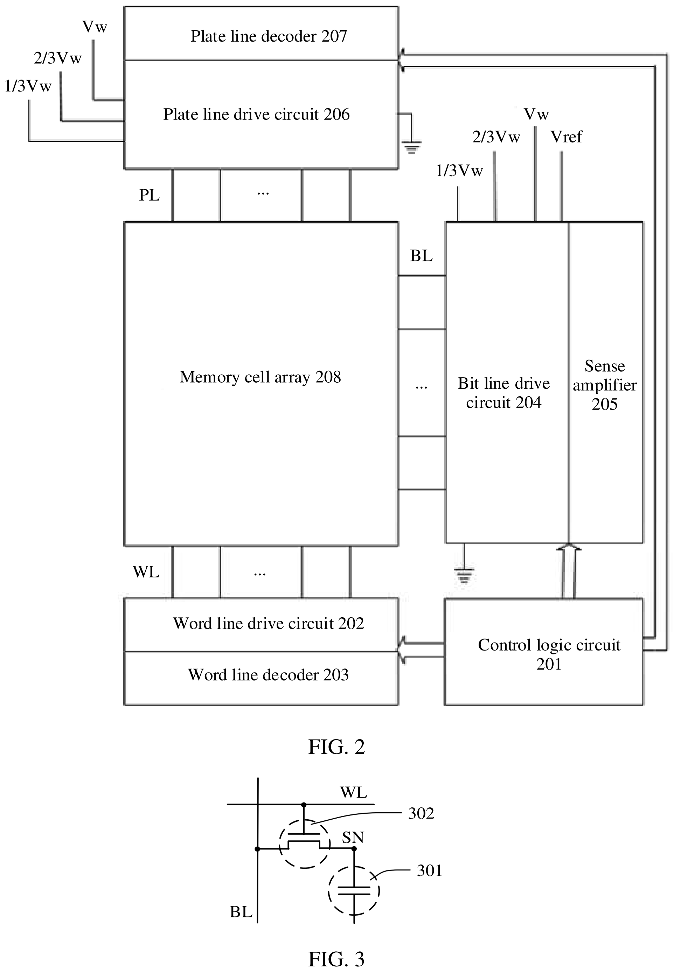

The memory 101 in the electronic device is described by using an example in which the memory 101 is a ferroelectric memory. FIG. 2 is a diagram of a structure of a memory according to an embodiment of this application. The memory 101 may include at least a control logic circuit 201, a word line drive circuit 202, a word line decoder 203, a bit line drive circuit 204, a sense amplifier (sense amplifier, SA) 205, a plate line drive circuit 206, a plate line decoder 207, and at least one memory cell array 208. Specific embodiments are not limited thereto, and may include fewer or more constituent components.

The memory cell array 208 may include a plurality of rows and a plurality of columns of memory cells (memory cell, MC). The plurality of rows and the plurality of columns of memory cells are coupled to a plurality of word lines (word line, WL), a plurality of bit lines (bit line, BL), and a plurality of plate lines (plate line, PL). The word line may be coupled to the word line drive circuit 202, and the word line drive circuit 202 may be coupled to the word line decoder 203. The bit line may be coupled to the bit line drive circuit 204, and the bit line drive circuit 204 may be coupled to the sense amplifier 205. The plate line may be coupled to the plate line drive circuit 206, and the plate line drive circuit 206 may be coupled to the plate line decoder 207.

The ferroelectric memory stores data by using a feature that a ferroelectric material of a memory cell can be spontaneously polarized and polarization strength can be reoriented under an action of a voltage. An example in which the memory cell includes a ferroelectric capacitor and the memory cell is coupled to a transistor is used for description. The word line is configured to conduct or cut off the transistor coupled to the memory cell, and the bit line and the plate line are configured to apply a voltage to the ferroelectric capacitor. When a voltage direction across two ends of the ferroelectric capacitor is different from a polarization direction, and a voltage across the two ends of the ferroelectric capacitor exceeds a coercive field voltage Vc, the polarization direction of the ferroelectric capacitor is switched. A switching charge formed when the polarization direction of the ferroelectric capacitor is switched is high, and a switching charge formed when the polarization direction of the ferroelectric capacitor is not switched is low. When the voltage is withdrawn, the polarization direction of the ferroelectric capacitor can still be kept. Such a binary stable state of the ferroelectric capacitor enables the ferroelectric capacitor to serve as the memory 101. Specifically, electric fields in a same direction are applied to two memory cells in different polarization directions, and switching charges of the two memory cells are different. In this way, the two memory cells may be configured to store data "0" and "1".

The ferroelectric memory includes structures such as one-transistor one-capacitor (1 transistor 1 capacitor, 1T1C), one-transistor multi-capacitor (1 transistor n capacitor, 1TnC), double-transistor double-capacitor (2 transistor 2 capacitor, 2T1C), and double-transistor one-capacitor (2 transistor 1 capacitor, 2T1C). The ferroelectric capacitor in the ferroelectric memory is referred to as a capacitor for short below.

In embodiments of this application, a transistor may be a metal-oxide-semiconductor field effect transistor (metal-oxide-semiconductor field effect transistor, MOSFET), and the transistor is classified into two types: an N (negative, negative)-type transistor and a P (positive, positive)-type transistor. The transistor includes a source (source), a drain (drain), and a gate (gate). Conduction or cut-off of the transistor may be controlled by controlling a level input to the gate of the transistor. For example, when a gate level of an N-type transistor is a high level, the N-type transistor is conducted, and a source and a drain are conducted and a conduction current is generated; or when a gate level of an N-type transistor is a low level, the N-type transistor is cut off, and a source and a drain are not conducted and a current is not generated. When a gate level of a P-type transistor is a low level, the P-type transistor is conducted, and a source and a drain are conducted and a conduction current is generated; or when a gate level of a P-type transistor is a high level, the P-type transistor is cut off, and a source and a drain are not conducted and a current is not generated. To describe embodiments of this application in detail, in this embodiment of this application, an example in which the transistor is an N-type transistor is used for description, but this is not intended to limit the solutions of this application.

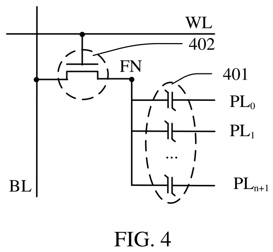

FIG. 3 is a diagram of a memory of a 1T1C structure according to an embodiment of this application. A gate of a transistor 302 is coupled to a WL, a first end of a source/drain of the transistor 302 and a first end of a capacitor 301 are coupled at a storage node (storage node, SN), and a second end of the source/drain of the transistor 302 is coupled to a BL. FIG. 4 is a diagram of a memory of a 1TnC structure according to an embodiment of this application. A gate of a transistor 402 is coupled to a WL, a first end of a source/drain of the transistor 402 and first ends of n capacitors 401 are coupled at a floating node (floating node, FN), and a second end of the source/drain of the transistor 402 is coupled to a BL. Second ends of the n capacitors are respectively coupled to n plate lines PL₀, PL₁, ..., and PLₙ₊₁.

In an example, if a polarization direction of a memory cell is from the second end of the capacitor to the first end of the capacitor, it indicates that the memory cell stores data 0; or if a polarization direction of the memory cell is from the first end of the capacitor to the second end of the capacitor, it indicates that the memory cell stores data 1. In another example, if a polarization direction of the memory cell is from the second end of the capacitor to the first end of the capacitor, it indicates that the memory cell stores data 1; or if a polarization direction of the memory cell is from the first end of the capacitor to the second end of the capacitor, it indicates that the memory cell stores data 0. To describe this embodiment of this application in detail, in this embodiment of this application, an example in which the polarization direction of the memory cell is from the second end of the capacitor to the first end of the capacitor and it indicates that the memory cell stores data 0 is used for description. However, this is not intended to limit the solutions of this application.

The memory 101 may be coupled to a memory controller, and receive a command (command, CMD), an address (address, ADD), and data (DATA) from the memory controller. For example, the CMD may include a write (write, WR) command, a read (read, RD) command, an active (active, ACT) command, and/or a precharge (precharge, PRE) command. The memory 101 may receive an address sent by the memory controller, and perform an operation of a corresponding command on data in a region selected based on the address.

Specifically, the control logic circuit 201 in the memory 101 controls the components in the memory 101 based on the received CMD, ADD, and DATA. For example, the control logic circuit 201 may send the address to the word line decoder 203 and the plate line decoder 207, and the word line decoder 203 and the plate line decoder 207 determine, based on the address, a word line and a plate line that correspond to a selected capacitor. The control logic circuit 201 may further send an instruction for applying a voltage to the word line drive circuit 202, the bit line drive circuit 204, and the plate line drive circuit 206, to control the word line drive circuit 202 to apply a voltage to the word line corresponding to the selected capacitor, control the bit line drive circuit 204 to apply a voltage to a bit line corresponding to the selected capacitor, and control the plate line drive circuit 206 to apply a voltage to the plate line corresponding to the selected capacitor. The sense amplifier may be configured to store data in the selected capacitor.

Miniaturization in size of a conventional planar dynamic random access memory (Dynamic Random Access Memory, DRAM) based on a 1T1C structure becomes increasingly difficult, and a three-dimensional ferroelectric memory based on a 1TnC structure can better improve a memory integration density. Similar to the conventional DRAM, in a read process, a change of a charge on a BL may cause a change of a voltage on the BL. The change of the voltage on the BL may be read and amplified by using an SA, and information about a capacitor may be read. Different from the conventional DRAM, the change of the charge on the BL is mainly caused by a polarization charge released by a ferroelectric medium due to polarity switching when the ferroelectric capacitor is under an action of a voltage that exceeds Vc. The following describes a memory cell array of a ferroelectric memory.

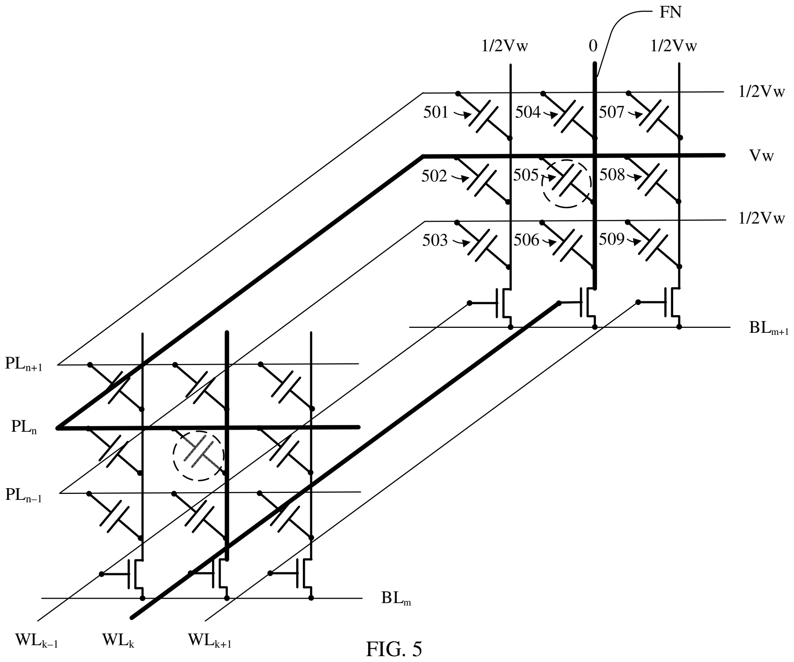

FIG. 5 is a diagram 1 of a memory cell array according to an embodiment of this application. Each capacitor forms one memory cell. FIG. 5 shows two memory cell arrays: a memory cell array A including nine memory cells in an upper right corner and a memory cell array B including nine memory cells in a lower left corner.

Memory cells located in a same column in each memory cell array are coupled to a same transistor and a same word line. For example, the memory cell array A includes three rows and three columns of memory cells, and is coupled to three transistors. In the memory cell array A, a 1^{st} column of memory cells (a capacitor 501, a capacitor 502, and a capacitor 503) is coupled to a same transistor and a WLₖ₋₁, a 2^{nd} column of memory cells (a capacitor 504, a capacitor 505, and a capacitor 506) is coupled to a same transistor and a WLₖ, and a 3^{rd} column of memory cells (a capacitor 507, a capacitor 508, and a capacitor 509) is coupled to a same transistor and a WLₖ₊₁. In addition, in the memory cell array B, a 1^{st} column of memory cells is coupled to a same transistor and the WLₖ₋₁, a 2^{nd} column of memory cells is coupled to a same transistor and the WLₖ, and a 3^{rd} column of memory cells is coupled to a same transistor and the WLₖ₊₁.

A plurality of transistors of each memory cell array are all coupled to a bit line. For example, three transistors corresponding to the nine memory cells in the memory cell array A are coupled to a BLₘ₊₁, and three transistors corresponding to the nine memory cells in the memory cell array B are coupled to a BLₘ.

Memory cells located in a same row in each memory cell array are coupled to a same plate line. For example, in the memory cell array A, a 1^{st} row of memory cells (the capacitor 501, the capacitor 504, and the capacitor 507) is coupled to a PLₙ₊₁, a 2^{nd} row of memory cells (the capacitor 502, the capacitor 505, and the capacitor 508) is coupled to a PLₙ, and a 3^{rd} row of memory cells (the capacitor 503, the capacitor 506, and the capacitor 509) is coupled to a PLₙ₋₁. In addition, in the memory cell array B, a 1^{st} row of memory cells is coupled to the PLₙ₊₁, a 2^{nd} row of memory cells is coupled to the PLₙ, and a 3^{rd} row of memory cells is coupled to the PLₙ₋₁.

In FIG. 5, a capacitor circled by a dashed line is a selected capacitor, and a capacitor not circled by a dashed line is an unselected capacitor. For example, the capacitor 505 is the selected capacitor, the WLₖ is a selected word line, and the PLₙ is a selected plate line. In a process of writing "0" into the capacitor 505, a word line drive circuit applies a high level to the WLₖ, so that a corresponding transistor is conducted, a bit line drive circuit applies a 0-volt voltage to the BLₘ₊₁, and a plate line drive circuit applies Vw to the PLₙ, where Vw>Vc. In this way, a voltage at an FN corresponding to the capacitor 504, the capacitor 505, and the capacitor 506 is 0. A voltage at a first end of the capacitor 505 is 0 and a voltage at a second end of the capacitor 505 is Vw, so that a polarization direction of the capacitor 505 is from the second end of the capacitor to the first end of the capacitor, and "0" is written into the capacitor 505.

To prevent polarization directions of the capacitor 502 and the capacitor 508 from changing to pointing from the second end of the capacitor to the first end of the capacitor,
the bit line drive circuit applies (1/2)Vw to the BLₘ₊₁, so that voltages at FNs corresponding to the capacitor 502 and the capacitor 508 are (1/2)Vw. In addition, (1/2)Vw<Vc, so that a voltage difference between two ends of each of the capacitor 502 and the capacitor 508 is less than Vc. Similarly, to prevent polarization directions of the capacitor 504 and the capacitor 506 from changing to pointing from the second end of the capacitor to the first end of the capacitor, the plate line drive circuit applies (1/2)Vw to the PLₙ₋₁ and the PLₙ₊₁.

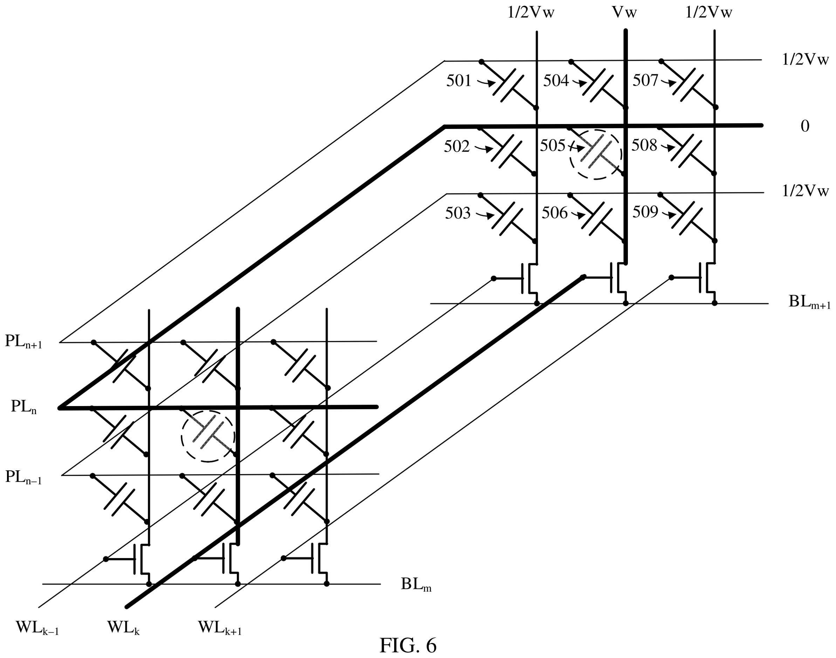

FIG. 6 is a diagram 2 of a memory cell array according to an embodiment of this application. In a process of writing "1" into the capacitor 505, the word line drive circuit applies a high level to the WLₖ, so that a corresponding transistor is conducted; the bit line drive circuit applies Vw to the BLₘ₊₁, and the plate line drive circuit applies a 0-volt voltage to the PLₙ. In this way, a voltage at an FN corresponding to the capacitor 504, the capacitor 505, and the capacitor 506 is Vw. A voltage at the first end of the capacitor 505 is Vw and a voltage at the second end of the capacitor 505 is 0, so that a polarization direction of the capacitor 505 is from the first end of the capacitor to the second end of the capacitor, and "1" is written into the capacitor 505.

To prevent polarization directions of the capacitor 504 and the capacitor 506 from changing to pointing from the second end of the capacitor to the first end of the capacitor, the plate line drive circuit applies (1/2)Vw to the PLₙ₋₁ and the PLₙ₊₁. To prevent polarization directions of the capacitor 502 and the capacitor 508 from changing to pointing from the second end of the capacitor to the first end of the capacitor, the bit line drive circuit applies (1/2)Vw to the BLₘ₊₁, so that voltages at FNs corresponding to the capacitor 502 and the capacitor 508 are (1/2)Vw.

It can be learned from the corresponding process of writing "0" in FIG. 5 and the corresponding process of writing "1" in FIG. 6 that a voltage of (1/2)Vw is applied to two ends of each of the capacitor 502, the capacitor 508, the capacitor 504, and the capacitor 506. If the capacitor is at a voltage of (1/2)Vw for a long time, spontaneous polarization strength of the capacitor is changed, and a size of an information reading window may be reduced. To reduce impact of a voltage difference between the two ends of the capacitor on the information reading window, when a ferroelectric memory is accessed, the ferroelectric capacitor needs to be refreshed periodically. If the capacitor has a low anti-interference capability for (1/2)Vw, the capacitor needs to be refreshed a plurality of times, and an excessively high refresh frequency cannot be implemented at a system level. Consequently, implementability of the ferroelectric memory is reduced. Therefore, a problem of high refresh frequency exists in the conventional technology.

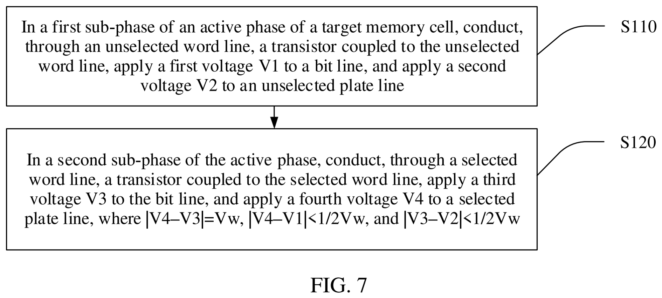

Based on this, an embodiment of this application provides a control method for a memory. FIG. 7 is a schematic flowchart of a control method for a memory according to an embodiment of this application. The memory may be a ferroelectric random access memory, a magnetic random access memory, a dynamic random access memory, or the like. The memory includes a plurality of transistors, a memory cell array, a bit line, a plurality of word lines, and a plurality of plate lines, memory cells located in a same column in the memory cell array are coupled to a same transistor and a same word line, the plurality of transistors are all coupled to the bit line, and memory cells located in a same row in the memory cell array are coupled to a same plate line. The method includes steps S110 and S120.

S110: In a first sub-phase of an active phase of a target memory cell, conduct, through an unselected word line, a transistor coupled to the unselected word line, apply a first voltage V1 to the bit line, and apply a second voltage V2 to an unselected plate line, where a word line and a plate line that are coupled to the target memory cell are respectively a selected word line and a selected plate line, the unselected word line is a word line other than the selected word line in the plurality of word lines, and the unselected plate line is a plate line other than the selected plate line in the plurality of plate lines.

S120: In a second sub-phase of the active phase, conduct, through the selected word line, a transistor coupled to the selected word line, apply a third voltage V3 to the bit line, and apply a fourth voltage V4 to the selected plate line, where |V4-V3|=Vw, |V4-V1|<(1/2)Vw, and |V3-V2|<(1/2)Vw. Specifically, Vw>Vc.

A process of accessing the memory cell array of a ferroelectric memory may be divided into three phases: an active (active, ACT) phase, a read/write (read/write, R/W) phase, and a precharge (precharge, PRH) phase.

In the active phase, a destructive "0" (or "1") writing operation is performed on the target memory cell, so that a switching charge released by the target memory cell is transmitted to a bit line corresponding to the target memory cell, and data in the target memory cell is stored, based on the voltage of the bit line, into a sense amplifier coupled to the bit line.

In the read/write phase, the data in the sense amplifier is read, or the data in the sense amplifier is rewritten.

In the precharge phase, the data in the sense amplifier is written back to the target memory cell, and the word line, the bit line, and the plate line are initialized.

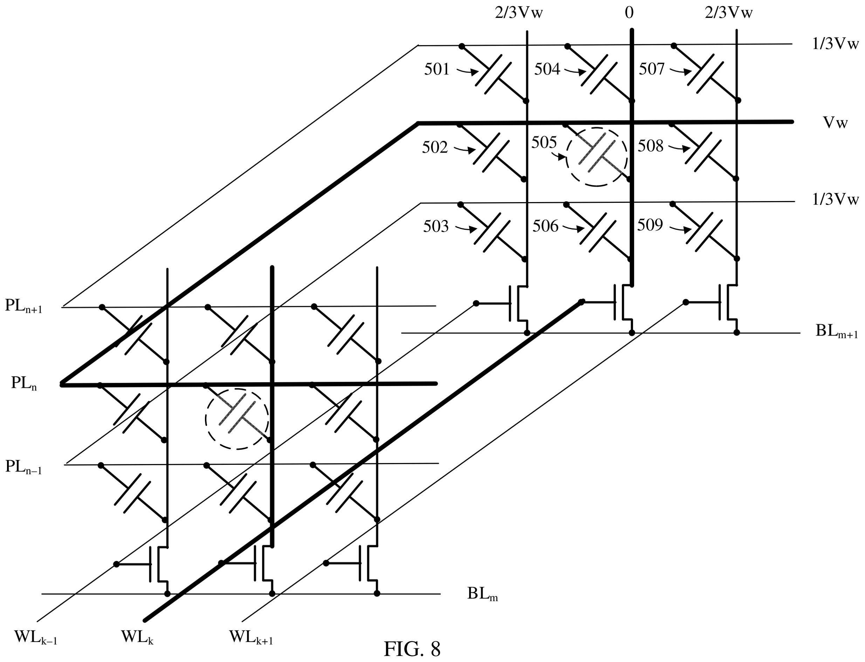

FIG. 8 is a diagram 3 of a memory cell array according to an embodiment of this application. A structure and a connection relationship of the memory cell array are the same as the structures and the connection relationships of the memory cell arrays in FIG. 5 and FIG. 6. Details are not described herein again in this embodiment of this application. As shown in FIG. 8, the target memory cell may be the selected capacitor 505, the selected word line may be the WLₖ corresponding to the capacitor 505, and the selected plate line may be the PLₙ coupled to the capacitor 505. The unselected word lines may be the WLₖ₋₁ and the WLₖ₊₁, and the unselected plate lines may be the PLₙ₋₁ and the PLₙ₊₁.

FIG. 8 is used as an example for description. In the first sub-phase of the active phase, the transistor coupled to the unselected word line is conducted through the unselected word line, and the first voltage V1 is applied to the bit line, so that voltages at FNs corresponding to the capacitor 502 and the capacitor 508 are V3. The second voltage V2 is applied to the unselected plate line, so that voltages at second ends of the capacitor 504 and the capacitor 506 are V2.

In the second sub-phase of the active phase, the transistor coupled to the selected word line is conducted through the selected word line, and the third voltage V3 is applied to the bit line, so that a voltage at an FN corresponding to the capacitor 504, the capacitor 505, and the capacitor 506 is V3. The fourth voltage V4 is applied to the selected plate line, so that voltages at second ends of the capacitor 502, the capacitor 505, and the capacitor 508 are V4.

If V4-V3=Vw, a polarization direction of the capacitor 505 is from the second end of the capacitor 505 to the first end of the capacitor 505, so that "0" is written into the capacitor 505. If V3-V4=Vw, the polarization direction of the capacitor 505 is from the first end of the capacitor 505 to the second end of the capacitor 505, so that "1" is written into the capacitor 505. In addition, a voltage difference between the two ends of each of the capacitor 502 and the capacitor 508 is |V4-V1|<(1/2)Vw, and a voltage difference between the two ends of each of the capacitor 504 and the capacitor 506 is |V3-V2|<(1/2)Vw.

According to the control method for a memory provided in this embodiment of this application, a voltage difference between two ends of the unselected memory cell other than the target memory cell in the memory cell array is reduced, that is, an amplitude of an interference voltage is reduced, so that read/write interference to the memory cell array is reduced, a size of an information read window is not reduced, a quantity of read/write interference resistance times of the memory cell array is increased, a refresh frequency of a ferroelectric memory is reduced, implementability of a ferroelectric memory is improved, and performance of the ferroelectric memory is enhanced.

In a possible implementation, |V4-V1|=|V3-V2|=|V1-V2|=(1/3)Vw. In this way, a voltage difference between the two ends of each of the capacitor 502, the capacitor 508, the capacitor 504, the capacitor 506, the capacitor 501, the capacitor 503, the capacitor 507, and the capacitor 509 may be (1/3)Vw.

According to the control method for a memory provided in this embodiment of this application, the voltage difference between the two ends of the unselected memory cell in the memory cell array other than the target memory cell is (1/3)Vw, so that the voltage difference between the two ends of the unselected memory cell is less than (1/2)Vw, a size of an information read window is not reduced, a refresh frequency of a ferroelectric memory is reduced, implementability of a ferroelectric memory is improved, and performance of the ferroelectric memory is enhanced.

In a possible implementation, the active phase is used to write first data into the target memory cell, V4=Vw, V3=0, V2=(1/3)Vw, and V1=(2/3)Vw; or the active phase is used to write second data into the selected memory cell, V4=0, V3=Vw, V2=(2/3)Vw, and V1=(1/3)Vw.

Writing the first data may be writing "0". As shown in FIG. 8, in the first sub-phase of the active phase, transistors coupled to the WLₖ₋₁ and the WLₖ₊₁ are conducted through the WLₖ₋₁ and the WLₖ₊₁, and (2/3)Vw is applied to the BLₘ₊₁, so that voltages at first ends of the 1^{st} column of memory cells (the capacitor 501, the capacitor 502, and the capacitor 503) and the 3^{rd} column of memory cells (the capacitor 507, the capacitor 508, and the capacitor 509) are (2/3)Vw. (1/3)Vw is applied to the PLₙ₋₁ and the PLₙ₊₁, so that voltages at second ends of the 1^{st} row of memory cells (the capacitor 501, the capacitor 504, and the capacitor 507) and the 3^{rd} row of memory cells (the capacitor 503, the capacitor 506, and the capacitor 509) are (1/3)Vw.

In the second sub-phase of the active phase, the transistor coupled to the selected word line is conducted through the WLₖ, and 0 is applied to the BLₘ₊₁, so that voltages at first ends of the 2^{nd} column of memory cells (the capacitor 504, the capacitor 505, and the capacitor 506) are 0. Vw is applied to the PLₙ, so that voltages at second ends of the 2^{nd} row of memory cells (the capacitor 502, the capacitor 505, and the capacitor 508) are Vw.

In this way, the voltage difference between the two ends of each of the capacitor 502, the capacitor 508, the capacitor 504, the capacitor 506, the capacitor 501, the capacitor 503, the capacitor 507, and the capacitor 509 may be (1/3)Vw in a process of accessing the memory cell array.

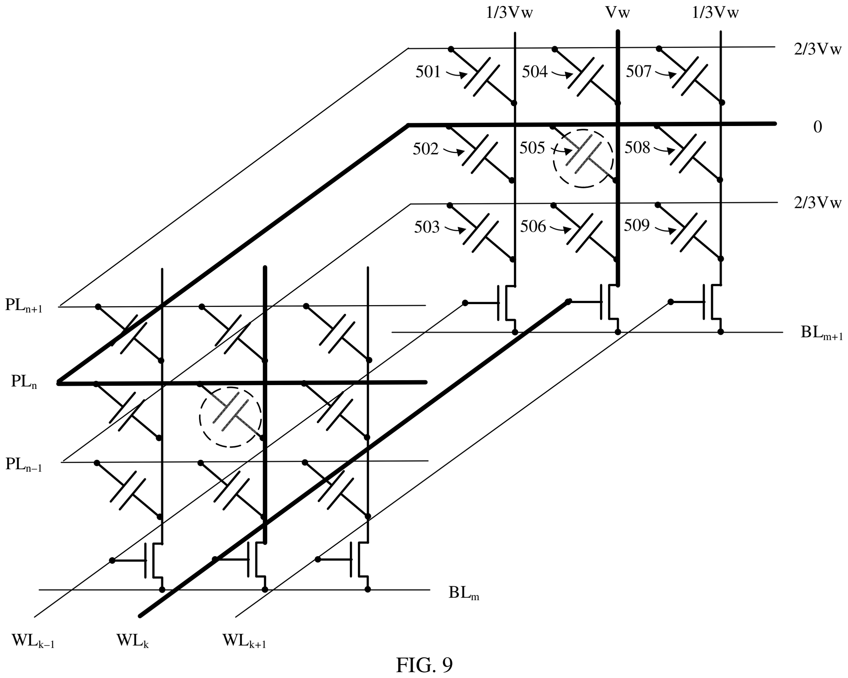

Alternatively, writing the second data may be writing "1". FIG. 9 is a diagram 4 of a memory cell array according to an embodiment of this application. As shown in FIG. 9, in the first sub-phase of the active phase, transistors coupled to the WLₖ₋₁ and the WLₖ₊₁ are conducted through the WLₖ₋₁ and the WLₖ₊₁, and (1/3)Vw is applied to the BLₘ₊₁, so that voltages at first ends of the 1^{st} column of memory cells (the capacitor 501, the capacitor 502, and the capacitor 503) and the 3^{rd} column of memory cells (the capacitor 507, the capacitor 508, and the capacitor 509) are (1/3)Vw. (2/3)Vw is applied to the PLₙ₋₁ and the PLₙ₊₁, so that voltages at second ends of the 1^{st} row of memory cells (the capacitor 501, the capacitor 504, and the capacitor 507) and the 3^{rd} row of memory cells (the capacitor 503, the capacitor 506, and the capacitor 509) are (2/3)Vw.

In the second sub-phase of the active phase, the transistor coupled to the selected word line is conducted through the WLₖ, and Vw is applied to the BLₘ₊₁, so that voltages at first ends of the 2^{nd} column of memory cells (the capacitor 504, the capacitor 505, and the capacitor 506) are Vw. 0 is applied to the PLₙ, so that voltages at second ends of the 2^{nd} row of memory cells (the capacitor 502, the capacitor 505, and the capacitor 508) are 0.

In this way, the voltage difference between the two ends of each of the capacitor 502, the capacitor 508, the capacitor 504, the capacitor 506, the capacitor 501, the capacitor 503, the capacitor 507, and the capacitor 509 may be (1/3)Vw in a process of accessing the memory cell array.

According to the control method for a memory provided in this embodiment of this application, the voltage difference between the two ends of the unselected memory cell in the memory cell array other than the target memory cell is (1/3)Vw, so that the voltage difference between the two ends of the unselected memory cell is less than (1/2)Vw, a size of an information read window is not reduced, a refresh frequency of a ferroelectric memory is reduced, implementability of a ferroelectric memory is improved, and performance of the ferroelectric memory is enhanced.

In a possible implementation, the memory further includes a sense amplifier coupled to the bit line, and if the active phase is used to write the first data into the target memory cell, before the applying the fourth voltage V4 to the selected plate line in the second sub-phase of the active phase, the method further includes: cutting off, through the selected word line, the transistor coupled to the selected word line.

The transistor coupled to the selected word line is conducted through the selected word line, the third voltage V3 is applied to the bit line, and the transistor coupled to the selected word line is cut off through the selected word line, so that the switching charge released by the target memory cell may be stored in the FN corresponding to the target memory cell.

After applying the fourth voltage V4 to the selected plate line, the method further includes: conducting, through the selected word line, the transistor coupled to the selected word line in a third sub-phase of the active phase; and storing first target data of the target memory cell into the sense amplifier based on a voltage of the bit line, where the first target data is the second data or the first data.

The transistor coupled to the selected word line is conducted through the selected word line, and charge sharing (charge sharing) occurs between the FN corresponding to the target memory cell and the bit line. In other words, the switching charge at the FN corresponding to the target memory cell is transmitted to the bit line. In this way, a change in the charge of the bit line causes a change in the voltage of the bit line. Based on a voltage change status of the bit line, it may be learned that the data stored in the target memory cell is "0" or "1".

According to the control method for a memory provided in this embodiment of this application, in a process of storing the first target data of the target memory cell into the sense amplifier, the voltage difference between the two ends of the unselected memory cell other than the target memory cell in the memory cell array is reduced, so that a size of an information read window is not reduced, a refresh frequency of a ferroelectric memory is reduced, implementability of a ferroelectric memory is improved, and performance of the ferroelectric memory is enhanced.

In a possible implementation, the method further includes: reading the first target data from the sense amplifier in a read phase of the target memory cell. According to the control method for a memory provided in this embodiment of this application, in a process of reading the first target data, the voltage difference between the two ends of the unselected memory cell other than the target memory cell in the memory cell array is reduced, so that a size of an information read window is not reduced, a refresh frequency of a ferroelectric memory is reduced, implementability of a ferroelectric memory is improved, and performance of the ferroelectric memory is enhanced.

In a possible implementation, the method further includes: deleting the first target data from and writing second target data into the sense amplifier in a write phase of the target memory cell, where the second target data is the second data or the first data. According to the control method for a memory provided in this embodiment of this application, in a process of writing the second target data, the voltage difference between the two ends of the unselected memory cell other than the target memory cell in the memory cell array is reduced, so that a size of an information read window is not reduced, a refresh frequency of a ferroelectric memory is reduced, implementability of a ferroelectric memory is improved, and performance of the ferroelectric memory is enhanced.

In a possible implementation, data in the sense amplifier is the second data, and the method further includes: in a first sub-phase of a precharge phase, conducting, through the unselected word line, the transistor coupled to the unselected word line, applying the second voltage V2 to the bit line, and applying the first voltage V1 to the unselected plate line; and in a second sub-phase of the precharge phase, conducting, through the selected word line, the transistor coupled to the selected word line, applying the fourth voltage V4 to the bit line, and applying the third voltage V3 to the selected plate line.

After the operation of writing "0" is performed on the target memory cell in the active phase, data in the target memory cell may be changed. Therefore, latest data in the sense amplifier needs to be rewritten into the target memory cell. If the data in the sense amplifier is "1", an operation of writing "1" is performed on the target memory cell through the foregoing steps, and in this process, the voltage difference between the two ends of the unselected memory cell is (1/3)Vw.

According to the control method for a memory provided in this embodiment of this application, in a process of performing precharge on the data in the sense amplifier, the voltage difference between the two ends of the unselected memory cell other than the target memory cell in the memory cell array is reduced, so that a size of an information read window is not reduced, a refresh frequency of a ferroelectric memory is reduced, implementability of a ferroelectric memory is improved, and performance of the ferroelectric memory is enhanced.

In a possible implementation, data in the sense amplifier is the first data, and the method further includes: in a first sub-phase of a precharge phase, conducting, through the unselected word line, the transistor coupled to the unselected word line, applying the second voltage V2 to the bit line, and applying the first voltage V1 to the unselected plate line; and in a second sub-phase of the precharge phase, conducting, through the selected word line, the transistor coupled to the selected word line, applying the second voltage V2 to the bit line, and applying the third voltage V3 to the selected plate line.

After the operation of writing "0" is performed on the target memory cell in the active phase, data in the target memory cell may be changed. Therefore, latest data in the sense amplifier needs to be rewritten into the target memory cell. If the data in the sense amplifier is "0", the data in the target memory cell remains "0" by performing the foregoing steps, and in this process, the voltage difference between the two ends of the unselected memory cell is (1/3)Vw.

According to the control method for a memory provided in this embodiment of this application, in a process of performing precharge on the data in the sense amplifier, the voltage difference between the two ends of the unselected memory cell other than the target memory cell in the memory cell array is reduced, so that a size of an information read window is not reduced, a refresh frequency of a ferroelectric memory is reduced, implementability of a ferroelectric memory is improved, and performance of the ferroelectric memory is enhanced.

In a possible implementation, the method further includes: separately applying the first voltage to the bit line, the selected plate line, and the unselected plate line in a third sub-phase of the precharge phase, to initialize the bit line, the selected plate line, and the unselected plate line.

According to the control method for a memory provided in this embodiment of this application, in a process of performing precharge on the data in the sense amplifier, the voltage difference between the two ends of the unselected memory cell other than the target memory cell in the memory cell array is reduced, so that a size of an information read window is not reduced, a refresh frequency of a ferroelectric memory is reduced, implementability of a ferroelectric memory is improved, and performance of the ferroelectric memory is enhanced.

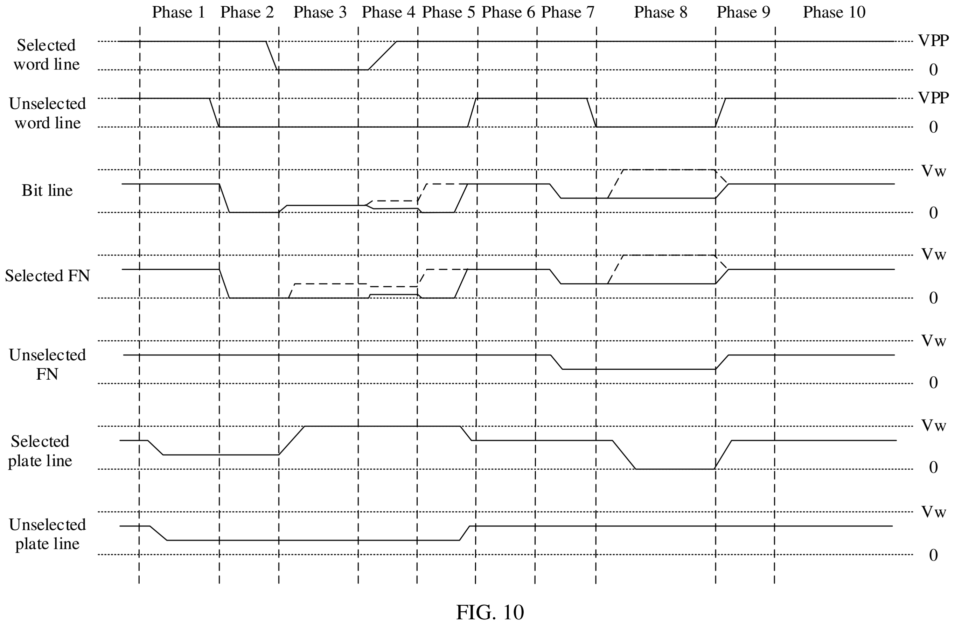

FIG. 10 is a time sequence diagram of a control method for a memory according to an embodiment of this application. For example, the following describes a control method for a memory provided in an embodiment of this application with reference to FIG. 10. A time sequence phase of accessing a target memory cell may be divided into 10 phases: a phase 1 to a phase 10. Initial voltages of a selected word line and an unselected word line are at a high level (VPP), and initial voltages of a bit line, an FN (referred to as a selected FN) corresponding to the target memory cell, an FN (referred to as an unselected FN) other than the selected FN in a memory cell array, a selected plate line, and an unselected plate line are (2/3)Vw.

A first sub-phase of an active phase may include the phase 1. In the phase 1, VPP is applied to the unselected word line to conduct a transistor coupled to the unselected word line. (2/3)Vw is applied to the bit line, so that a voltage at the unselected FN is (2/3)Vw. (1/3)Vw is applied to the unselected plate line, so that a voltage difference between two ends of the unselected memory cell is (1/3)Vw. Optionally, (1/3)Vw may be further applied to the selected plate line in the phase 1.

A second sub-phase of the active phase may include the phase 2 and the phase 3. In the phase 2, 0 is applied to the unselected word line, to cut off the transistor coupled to the unselected word line. VPP is applied to the selected word line, to conduct a transistor coupled to the selected word line. 0 is applied to the bit line, so that the voltage at the selected FN is 0.

In the phase 3, Vw is applied to the selected plate line, so that a voltage difference between the two ends of the target memory cell is Vw, and a voltage direction is from a second end of a capacitor to a first end of the capacitor. If an original polarization direction of the target memory cell is from the second end of the capacitor to the first end of the capacitor, that is, first target data of the target memory cell is "0", the polarization direction remains unchanged, and a switching charge released by the target memory cell is low. If the original polarization direction of the target memory cell is from the first end of the capacitor to the second end of the capacitor, that is, the first target data of the target memory cell is "1", the polarization direction is switched to pointing from the second end of the capacitor to the first end of the capacitor, and the switching charge released by the target memory cell is high. In this way, "0" may be written into the target memory cell.

In addition, in the phase 3, before Vw is applied to the selected plate line, 0 is applied to the selected word line to cut off the transistor coupled to the selected word line, and a reference voltage (reference voltage, Vref) is applied to the bit line. In this way, when Vw is applied to the selected plate line, the switching charge released by the target memory cell is stored at the selected FN. If the first target data of the target memory cell is "0", the voltage at the selected FN increases; or if the first target data of the target memory cell is "1", the voltage at the selected FN remains 0.

A third sub-phase of the active phase may include the phase 4 and the phase 5. In the phase 4, VPP is applied to the selected word line to conduct the transistor coupled to the selected word line, and the switching charge stored at the FN is transferred to the bit line. If the first target data of the target memory cell is "0", a voltage of the bit line is higher than the reference voltage. If the first target data of the target memory cell is "1", the voltage of the bit line is lower than the reference voltage.

The memory may include a plurality of levels of sense amplifiers, and the bit line is coupled to a first-level sense amplifier. A voltage amplification range (rail to rail) of the first-level sense amplifier may be 0 to (2/3)Vw. A switch may be disposed between the first-level sense amplifier and the bit line.

In the phase 5, the first-level sense amplifier is activated, and the voltage of the bit line is received by using the first-level sense amplifier. If the voltage of the bit line is higher than the reference voltage, the voltage of the bit line is amplified to (2/3)Vw by using the sense amplifier. If the voltage of the bit line is lower than the reference voltage, the voltage of the bit line is reduced to 0 by using the sense amplifier. The switch between the first-level sense amplifier and the bit line is turned off, so that the first-level sense amplifier is disconnected from the bit line. (2/3)Vw is applied to the bit line, so that the voltage of the bit line is restored to (2/3)Vw, and a state of the first-level sense amplifier is kept. Optionally, in the phase 5, VPP may be further applied to the selected word line, and (2/3)Vw may be applied to the selected plate line and the unselected plate line.

A read/write phase may include the phase 6. Specifically, the phase 6 may be a read phase, or may be a write phase. If the phase 6 is a read phase, in the phase 6, a column selection switch is turned on based on a column address, and the column selection switch is coupled to the bit line. A result of the first-level sense amplifier is read to a next-level sense amplifier until the result is read to an input/output (input output, I/O) interface, so that the first target data can be read from the first-level sense amplifier. If the phase 6 is a write phase, in the phase 6, second target data is stored in the first-level sense amplifier from the I/O interface, to delete the first target data from the sense amplifier and write the second target data into the sense amplifier.

A first sub-phase of a precharge phase may include the phase 7. In the phase 7, VPP is applied to the unselected word line, to conduct the transistor coupled to the unselected word line. (1/3)Vw is applied to the bit line, so that a voltage at the unselected FN is (1/3)Vw. (2/3)Vw is applied to the unselected plate line, so that a voltage difference between the two ends of the unselected memory cell is (1/3)Vw. Optionally, VPP may also be applied to the selected word line in the phase 7 to conduct the transistor coupled to the selected word line, so that the voltage at the selected FN is (1/3)Vw.

A second sub-phase of the precharge phase may include the phase 8. In the phase 8, 0 is applied to the unselected word line, to cut off the transistor coupled to the unselected word line. The voltage amplification range of the sense amplifier is increased from 0 to (2/3)Vw to (1/3)Vw to Vw. The switch between the first-level sense amplifier and the bit line is turned on, so that the first-level sense amplifier is connected to the bit line.

If latest data in the first-level sense amplifier is "1", VPP is applied to the selected word line, so that the transistor coupled to the selected word line is conducted, and Vw is applied to the bit line, so that the voltage at the selected FN is Vw. 0 is applied to the selected plate line, so that a voltage difference between the two ends of the target memory cell is Vw, and the voltage direction is from the first end of the capacitor to the second end of the capacitor. The polarization direction of the target memory cell is switched to pointing from the first end of the capacitor to the second end of the capacitor. In this way, "1" may be written back to the target memory cell.

If latest data in the first-level sense amplifier is "0", VPP is applied to the selected word line, so that the transistor coupled to the selected word line is conducted, and (1/3)Vw is applied to the bit line, so that the voltage at the selected FN is (1/3)Vw. 0 is applied to the selected plate line, so that a voltage difference between the two ends of the target memory cell is (1/3)Vw. The polarization direction of the target memory cell remains unchanged. In this way, "0" may be written back to the target memory cell.

A third sub-phase of the precharge phase may include the phase 9. (2/3)Vw is separately applied to the bit line, the selected plate line, and the unselected plate line to initialize the bit line, the selected plate line, and the unselected plate line. Optionally, in the phase 9, VPP may be further applied to the unselected word line and the selected word line, to initialize the unselected bit line and the selected word line. The phase 10 is a standby (standby) phase.

In a possible implementation, the method further includes: performing voltage division on an initial voltage according to different ratios, to obtain the first voltage and the second voltage. Optionally, the memory may include a voltage divider circuit, and the voltage divider circuit may include a first voltage divider circuit and a second voltage divider circuit. The first voltage divider circuit is configured to perform voltage division to obtain (1/3)Vw, and the second voltage divider circuit is configured to perform voltage division to obtain (2/3)Vw. Optionally, the voltage divider circuit may further include a third voltage divider circuit and a fourth voltage divider circuit. The third voltage divider circuit is configured to perform voltage division to obtain Vw, and the fourth voltage divider circuit is configured to perform voltage division to obtain a reference voltage.

According to the control method for a memory provided in this embodiment of this application, the first voltage and the second voltage are obtained through voltage division, to provide a basis for reducing the voltage difference between the two ends of the unselected memory cell other than the target memory cell in the memory cell array, so that a size of an information read window is not reduced, a refresh frequency of a ferroelectric memory is reduced, implementability of a ferroelectric memory is improved, and performance of the ferroelectric memory is enhanced.

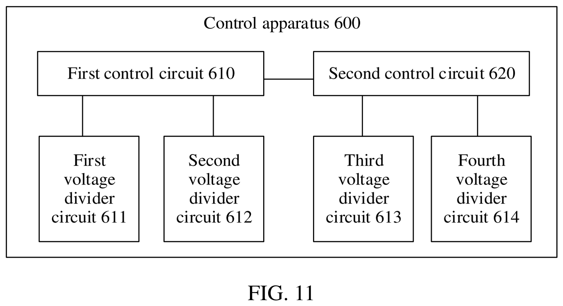

An embodiment of this application further provides a memory. FIG. 11 is a diagram of a structure of a control apparatus for a memory according to an embodiment of this application. The memory includes a plurality of transistors, a memory cell array, a bit line, a plurality of word lines, and a plurality of plate lines, memory cells located in a same column in the memory cell array are coupled to a same transistor and a same word line, the plurality of transistors are all coupled to the bit line, and memory cells located in a same row in the memory cell array are coupled to a same plate line. The apparatus 600 includes:
a first control circuit 610, configured to: in a first sub-phase of an active phase of a target memory cell, conduct, through an unselected word line, a transistor coupled to the unselected word line, apply a first voltage V1 to the bit line, and apply a second voltage V2 to an unselected plate line, where a word line and a plate line that are coupled to the target memory cell are respectively a selected word line and a selected plate line, the unselected word line is a word line other than the selected word line in the plurality of word lines, and the unselected plate line is a plate line other than the selected plate line in the plurality of plate lines; and
a second control circuit 620, configured to: in a second sub-phase of the active phase, conduct, through the selected word line, a transistor coupled to the selected word line, apply a third voltage V3 to the bit line, and apply a fourth voltage V4 to the selected plate line, where |V4-V3|=Vw, |V4-V1|<1/2Vw, and |V3-V2|<1/2Vw.

Optionally, the memory may further include a word line drive circuit, a word line decoder, a bit line drive circuit, a sense amplifier, a plate line drive circuit, and a plate line decoder. The memory may include a plurality of memory cell arrays. For a structure of each memory cell array, refer to FIG. 8 or FIG. 9.

In a possible implementation, |V4-V1|=|V3-V2|=|V1-V2|=(1/3)Vw.

In a possible implementation, the active phase is used to write first data into the target memory cell, V4=Vw, V3=0, V2=(1/3)Vw, and V1=(2/3)Vw; or the active phase is used to write second data into the selected memory cell, V4=0, V3=Vw, V2=(2/3)Vw, and V1=(1/3)Vw.

In a possible implementation, the memory further includes a sense amplifier coupled to the bit line, and the active phase is used to write the first data into the target memory cell. The second control circuit 620 is further configured to: before the fourth voltage V4 is applied to the selected plate line in the second sub-phase of the active phase, cut off, through the selected word line, the transistor coupled to the selected word line. The second control circuit 620 is further configured to conduct, through the selected word line, the transistor coupled to the selected word line in a third sub-phase of the active phase. The second control circuit 620 is further configured to store first target data of the target memory cell into the sense amplifier based on a voltage of the bit line, where the first target data is the second data or the first data.

In a possible implementation, the apparatus 600 further includes a third control circuit, configured to read the first target data from the sense amplifier in a read phase of the target memory cell.

In a possible implementation, the apparatus 600 further includes a fourth control circuit, configured to: delete the first target data from and write second target data into the sense amplifier in a write phase of the target memory cell, where the second target data is the second data or the first data.

In a possible implementation, data in the sense amplifier is the second data, and the first control circuit 610 is further configured to: in a first sub-phase of a precharge phase, conduct, through the unselected word line, the transistor coupled to the unselected word line, apply the second voltage V2 to the bit line, and apply the first voltage V1 to the unselected plate line. The second control circuit 620 is further configured to: in a second sub-phase of the precharge phase, conduct, through the selected word line, the transistor coupled to the selected word line, apply the fourth voltage V4 to the bit line, and apply the third voltage V3 to the selected plate line.

In a possible implementation, data in the sense amplifier is the first data, and the first control circuit 610 is further configured to: in a first sub-phase of a precharge phase, conduct, through the unselected word line, the transistor coupled to the unselected word line, apply the second voltage V2 to the bit line, and apply the first voltage V1 to the unselected plate line. The second control circuit 620 is further configured to: in a second sub-phase of the precharge phase, conduct, through the selected word line, the transistor coupled to the selected word line, apply the second voltage V2 to the bit line, and apply the third voltage V3 to the selected plate line.

In a possible implementation, the apparatus 600 further includes a fifth control circuit, configured to separately apply the first voltage to the bit line, the selected plate line, and the unselected plate line in a third sub-phase of the precharge phase, to initialize the bit line, the selected plate line, and the unselected plate line.

In a possible implementation, the apparatus 600 further includes a voltage divider circuit, and the voltage divider circuit is configured to perform voltage division on an initial voltage according to different ratios, to obtain the first voltage and the second voltage. Specifically, the voltage divider circuit may include a first voltage divider circuit 611 and a second voltage divider circuit 612. The first voltage divider circuit 611 is configured to perform voltage division to obtain (1/3)Vw, and the second voltage divider circuit 612 is configured to perform voltage division to obtain (2/3)Vw. Optionally, the voltage divider circuit may further include a third voltage divider circuit 613 and a fourth voltage divider circuit 614. The third voltage divider circuit 613 is configured to perform voltage division to obtain Vw, and the fourth voltage divider circuit 614 is configured to perform voltage division to obtain a reference voltage. The first control circuit may be separately coupled to the first voltage divider circuit 611, the second voltage divider circuit 612, and the fourth voltage divider circuit 614, and is configured to receive (1/3)Vw, (2/3)Vw and Vref. The bit line drive circuit may be separately coupled to the third voltage divider circuit 613 and the fourth voltage divider circuit 614, and is configured to receive Vw and Vref.

The control apparatus for a memory provided in this embodiment of this application may implement functions and effects of the foregoing method embodiments. This has been described in the foregoing method embodiments, and details are not described herein again.

An embodiment of this application further provides an electronic device. As shown in FIG. 1, the electronic device may include one or more memories 101, and the memory 101 may include the control apparatus 600 for a memory.

The electronic device may be a mobile phone, a desktop computer, a laptop computer, a tablet computer, a vehicle computer, a game console, a printer, a positioning device, a smart sensor of a wearable electronic device, a virtual reality (VR) device, an augmented reality (AR) device, or any other suitable electronic device having a memory therein. The electronic device may further include a processor 102, a sensor component 103, a multimedia component 104, and an input/output interface 105.

In some embodiments, the processor 102 may be a single-processor structure, a multi-processor structure, a single-thread processor, a multi-thread processor, or the like. In some embodiments, the processor 102 may include at least one of a central processing unit, a general-purpose processor, a digital signal processor, a neural network processor, a graphics processing unit (graphics processing unit, GPU), an image signal processor, a microcontroller, a microprocessor, or the like. In addition, the processor 102 may further include another hardware circuit or accelerator, for example, an application-specific integrated circuit, a field programmable gate array or another programmable logic device, a transistor logic device, a hardware component, or any combination thereof. The controller/processor may implement or execute various example logical blocks, modules, and circuits described with reference to content disclosed in embodiments of this application. Alternatively, the processor 102 may be a combination of processors implementing a computing function, for example, a combination including one or more microprocessors, or a combination of a digital signal processor and a microprocessor.

The sensor component 103 includes one or more sensors configured to provide the electronic device with status assessment in various aspects. For example, the sensor component 103 may include an optical sensor, such as a complementary metal oxide semiconductor (complementary metal oxide semiconductor, CMOS) image sensor or a charge coupled device (charge coupled device, CCD) image sensor, and is configured to be used in an imaging application, that is, become a component of a camera or a camera.

The multimedia component 104 provides a display panel of an output interface between the electronic device and a user, and the display panel may be a touch panel. The touch panel includes one or more touch sensors to sense touches, sliding, and gestures on the touch panel. The touch sensor may not only sense a boundary of a touch or slide action, but also detect duration and pressure that are related to the touch or slide operation. In addition, the multimedia component 104 further includes at least one camera. When the electronic device is in an operation mode, for example, a photographing mode or a video mode, the camera may sense an external multimedia signal, and the signal is used to form an image frame. Each camera may be a fixed optical lens system or have focusing and optical zooming capabilities.

The input/output interface 105 is configured to provide an interface between the processor 102 and a peripheral interface module. In a possible implementation, there may be only one or more input/output interfaces 105.

The electronic device provided in this embodiment of this application may implement functions and effects of the foregoing method embodiments. This has been described in the foregoing method embodiments, and details are not described herein again.

Based on such an understanding, an embodiment of this application further provides a computer program product including instructions. The technical solutions of this application essentially, or the part contributing to the conventional technology, or all or some of the technical solutions may be implemented in a form of a software product. The computer software product is stored in a storage medium, and includes several instructions for instructing a computer device (which may be a personal computer, a server, a network device, or the like) or a storage system in the computer device to perform all or some of the steps of the methods described in embodiments of this application.

In conclusion, the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A control method for a memory, wherein the memory comprises a plurality of transistors, a memory cell array, a bit line, a plurality of word lines, and a plurality of plate lines, memory cells located in a same column in the memory cell array are coupled to a same transistor and a same word line, the plurality of transistors are all coupled to the bit line, and memory cells located in a same row in the memory cell array are coupled to a same plate line; and the method comprises:
in a first sub-phase of an active phase of a target memory cell, conducting, through an unselected word line, a transistor coupled to the unselected word line, applying a first voltage V1 to the bit line, and applying a second voltage V2 to an unselected plate line, wherein a word line and a plate line that are coupled to the target memory cell are respectively a selected word line and a selected plate line, the unselected word line is a word line other than the selected word line in the plurality of word lines, and the unselected plate line is a plate line other than the selected plate line in the plurality of plate lines; and
in a second sub-phase of the active phase, conducting, through the selected word line, a transistor coupled to the selected word line, applying a third voltage V3 to the bit line, and applying a fourth voltage V4 to the selected plate line, wherein |V4-V3|=Vw, |V4-V1|<1/2Vw, and |V3-V2|<1/2Vw.

2. The method according to claim 1, wherein |V4-V1|=|V3-V2|=|V1-V2|=(1/3)Vw.

3. The method according to claim 1 or 2, wherein the active phase is used to write first data into the target memory cell, V4=Vw, V3=0, V2=(1/3)Vw, and V1=(2/3)Vw; or
the active phase is used to write second data into the selected memory cell, V4=0, V3=Vw, V2=(2/3)Vw, and V1=(1/3)Vw.

4. The method according to claim 3, wherein the memory further comprises a sense amplifier coupled to the bit line, and if the active phase is used to write the first data into the target memory cell, before the applying the fourth voltage V4 to the selected plate line in the second sub-phase of the active phase, the method further comprises:
cutting off, through the selected word line, the transistor coupled to the selected word line; and
after applying the fourth voltage V4 to the selected plate line, the method further comprises:
conducting, through the selected word line, the transistor coupled to the selected word line in a third sub-phase of the active phase; and
storing first target data of the target memory cell into the sense amplifier based on a voltage of the bit line,
wherein the first target data is the second data or the first data.

5. The method according to claim 4, wherein the method further comprises:
reading the first target data from the sense amplifier in a read phase of the target memory cell.

6. The method according to claim 4, wherein the method further comprises:
deleting the first target data from and writing second target data into the sense amplifier in a write phase of the target memory cell, wherein the second target data is the second data or the first data.

7. The method according to claim 5 or 6, wherein data in the sense amplifier is the second data, and the method further comprises:
in a first sub-phase of a precharge phase, conducting, through the unselected word line, the transistor coupled to the unselected word line, applying the second voltage V2 to the bit line, and applying the first voltage V1 to the unselected plate line; and
in a second sub-phase of the precharge phase, conducting, through the selected word line, the transistor coupled to the selected word line, applying the fourth voltage V4 to the bit line, and applying the third voltage V3 to the selected plate line.

8. The method according to claim 5 or 6, wherein data in the sense amplifier is the first data, and the method further comprises:
in a first sub-phase of a precharge phase, conducting, through the unselected word line, the transistor coupled to the unselected word line, applying the second voltage V2 to the bit line, and applying the first voltage V1 to the unselected plate line; and
in a second sub-phase of the precharge phase, conducting, through the selected word line, the transistor coupled to the selected word line, applying the second voltage V2 to the bit line, and applying the third voltage V3 to the selected plate line.

9. The method according to any one of claims 1 to 8, wherein the method further comprises:
separately applying the first voltage to the bit line, the selected plate line, and the unselected plate line in a third sub-phase of the precharge phase, to initialize the bit line, the selected plate line, and the unselected plate line.

10. The method according to any one of claims 1 to 9, wherein the method further comprises:
performing voltage division on an initial voltage according to different ratios, to obtain the first voltage and the second voltage.

11. A control apparatus for a memory, wherein the memory comprises a plurality of transistors, a memory cell array, a bit line, a plurality of word lines, and a plurality of plate lines, memory cells located in a same column in the memory cell array are coupled to a same transistor and a same word line, the plurality of transistors are all coupled to the bit line, and memory cells located in a same row in the memory cell array are coupled to a same plate line; and the apparatus comprises:
a first control circuit, configured to: in a first sub-phase of an active phase of a target memory cell, conduct, through an unselected word line, a transistor coupled to the unselected word line, apply a first voltage V1 to the bit line, and apply a second voltage V2 to an unselected plate line, wherein a word line and a plate line that are coupled to the target memory cell are respectively a selected word line and a selected plate line, the unselected word line is a word line other than the selected word line in the plurality of word lines, and the unselected plate line is a plate line other than the selected plate line in the plurality of plate lines; and
a second control circuit, configured to: in a second sub-phase of the active phase, conduct, through the selected word line, a transistor coupled to the selected word line, apply a third voltage V3 to the bit line, and apply a fourth voltage V4 to the selected plate line, wherein |V4-V3|=Vw, |V4-V1|<1/2Vw, and |V3-V2|<1/2Vw.

12. The control apparatus according to claim 11, wherein |V4-V1|=|V3-V2|=|V1-V2|=(1/3)Vw.

13. The control apparatus according to claim 11 or 12, wherein the active phase is used to write first data into the target memory cell, V4=Vw, V3=0, V2=(1/3)Vw, and V1=(2/3)Vw; or
the active phase is used to write second data into the selected memory cell, V4=0, V3=Vw, V2=(2/3)Vw, and V1=(1/3)Vw.

14. The control apparatus according to claim 13, wherein the memory further comprises a sense amplifier coupled to the bit line, and the active phase is used to write the first data into the target memory cell;
the second control circuit is further configured to: before the fourth voltage V4 is applied to the selected plate line in the second sub-phase of the active phase, cut off, through the selected word line, the transistor coupled to the selected word line;
the second control circuit is further configured to conduct, through the selected word line, the transistor coupled to the selected word line in a third sub-phase of the active phase; and
the second control circuit is further configured to store first target data of the target memory cell into the sense amplifier based on a voltage of the bit line, wherein the first target data is the second data or the first data.

15. The control apparatus according to claim 14, wherein the apparatus further comprises:
a third control circuit, configured to read the first target data from the sense amplifier in a read phase of the target memory cell.

16. The control apparatus according to claim 14, wherein the apparatus further comprises:
a fourth control circuit, configured to: delete the first target data from and write second target data into the sense amplifier in a write phase of the target memory cell, wherein the second target data is the second data or the first data.

17. The control apparatus according to claim 15 or 16, wherein data in the sense amplifier is the second data, and the first control circuit is further configured to: in a first sub-phase of a precharge phase, conduct, through the unselected word line, the transistor coupled to the unselected word line, apply the second voltage V2 to the bit line, and apply the first voltage V1 to the unselected plate line; and
the second control circuit is further configured to: in a second sub-phase of the precharge phase, conduct, through the selected word line, the transistor coupled to the selected word line, apply the fourth voltage V4 to the bit line, and apply the third voltage V3 to the selected plate line.

18. The control apparatus according to claim 15 or 16, wherein data in the sense amplifier is the first data, and the first control circuit is further configured to: in a first sub-phase of a precharge phase, conduct, through the unselected word line, the transistor coupled to the unselected word line, apply the second voltage V2 to the bit line, and apply the first voltage V1 to the unselected plate line; and
the second control circuit is further configured to: in a second sub-phase of the precharge phase, conduct, through the selected word line, the transistor coupled to the selected word line, apply the second voltage V2 to the bit line, and apply the third voltage V3 to the selected plate line.

19. The control apparatus according to any one of claims 11 to 18, wherein the apparatus further comprises:
a fifth control circuit, configured to separately apply the first voltage to the bit line, the selected plate line, and the unselected plate line in a third sub-phase of the precharge phase, to initialize the bit line, the selected plate line, and the unselected plate line.

20. The control apparatus according to any one of claims 11 to 19, wherein the apparatus further comprises a voltage divider circuit, and the voltage divider circuit is configured to perform voltage division on an initial voltage according to different ratios, to obtain the first voltage and the second voltage.

21. An electronic device, wherein the electronic device comprises a processor and the control apparatus for a memory according to any one of claims 11 to 20.
